# EUROPEAN PATENT APPLICATION

(11) **EP 0 921 400 A2**
(43) Date of publication of application: **09.06.1999**
(21) Application number: 98309174.5
(22) Date of filing: 10.11.1998
(51) Int. Cl.: G01R 1/07

(54) **Terminal apparatus for electro-optic probe**

(30) Priority: 11.11.1997 JP 30889597
(71) Applicant: ANDO ELECTRIC CO., LTD., Tokyo 144 (JP); NIPPON TELEGRAPH AND TELEPHONE CORPORATION, Tokyo 160 (JP)
(72) Inventor: Takeuchi, Nobuaki c/o Ando Electric Co.Ltd., Ota-ku, Tokyo (JP); Yanagisawa, Yoshiki c/o Ando Electric Co.Ltd., Ota-ku, Tokyo (JP); Kikuchi, Jun c/o Ando Electric Co.Ltd., Ota-ku, Tokyo (JP); Endou, Yoshio c/o Ando Electric Co.Ltd., Ota-ku, Tokyo (JP); Shinagawa, Mitsuru Nippon Telegr. and Teleph.Corp., Shinjuku-ku, Tokyo (JP); Nagatsuma,Tadao c/o Nippon Telegr. and Teleph.Corp, Shinjuku-ku, Tokyo (JP); Matsuhiro, Kazuyoshi Nippon Telegr.and Teleph.Corp, Shinjuku-ku, Tokyo (JP)
(74) Representative: Read, Matthew Charles

(57) **Abstract**

A terminal apparatus is provided for an electro-optic sampling probe that performs measurement on signals transmitted on a distribution constant transmission path such as a coaxial cable. The terminal apparatus supports a projection portion of the electro-optic sampling probe. In the terminal apparatus, an electrode such as a center electrode of a connector connected with the distribution constant transmission path is placed in an electric connection with a contact provided at a tip end of the projection portion of the electro-optic sampling probe. The terminal apparatus has a terminal circuit, which performs termination process on the distribution constant transmission path. Herein, the terminal circuit has impedance which is substantially equivalent to impedance of the distribution constant transmission path. For example, the terminal circuit is configured using a terminal resistor which is connected to the electrode. Due to the termination process which is performed by the terminal apparatus with respect to the distribution constant transmission path, the electro-optic sampling probe is capable of performing high-precision measurement in a stable manner on (potentials of) signals transmitted on the distribution constant transmission path.

## Description

### BACKGROUND OF THE INVENTION

### Field of the Invention

This invention relates to terminal apparatuses that use electro-optic sampling probes (or electro-optic probes) to perform measurement with respect to signals on distribution constant transmission paths.

This application is based on Patent Application No. Hei 9-308895 filed in Japan, the content of which is incorporated herein by reference.

### Description of the Related Art

Conventionally, oscilloscopes are widely used for measurement of waveforms of rapidly varying electric phenomena. To cope with inspection, maintenance and measurement for the information communication systems which perform high-speed communications in these days, it is demanded that the oscilloscopes have capabilities to perform high-precision detection on potentials of signals on measured circuits without imparting disturbances to the measured circuits. Until now, however, the communications technology do not provide such high-precision oscilloscopes that use sufficiently high impedance to measure high-frequency signals, frequencies of which may be increased up to 5 GHz, for example.

Measurement is performed on potentials of signals on the measured circuits fabricated on the printed-circuit boards of the information communication systems without imparting disturbances to the measured circuits. In order to do so, there are provided handy-type electro-optic sampling probes. The electro-optic sampling probe is constructed by an electro-optic material, which is made of BSO (i.e., Bi₁₂SiO₂₀) and to which a dielectric mirror is attached. Herein, a contact is attached to one end of the electro-optic material. The contact is brought into contact with a conduction path such as a microstrip line, for example. Using the contact, it is possible to detect signals on the microstrip line. Those signals are detected in form of potential differences at ends of the electro-optic material. Then, a birefringence ratio of light is varied in response to variations of strength of electric field corresponding to the potential differences. Variations of the birefringence ratio result in variations of polarization of laser beams, which are incident on the electro-optic material. Then, the dielectric mirror extracts the laser beams subjected to variations of polarization, which are supplied to a polarization detection optical system of a probe module, wherein the laser beams are processed to perform measurement of voltages with respect to the signals of the measured circuits.

The aforementioned electro-optic sampling probes are capable of measuring voltages of signals having high frequencies, which are higher than 5 GHz, for example. Herein, a measurement point is determined in such a way that the contact of the electro-optic sampling probe is brought into "direct" contact with a "bare" conduction portion such as the microstrip line. For this reason, the conventional technology suffers from a problem that the foregoing electro-optic sampling probe cannot perform "direct" measurement on potentials of signals which pass through a conductor (or a core line) of a coaxial cable connecting circuits, for example.

In the case where the electro-optic sampling probe incompletely performs contact operation that the contact thereof is brought into contact with the conduction portion, the conventional technology suffers from the following problem:

Because input impedance of the electro-optic sampling probe is extremely high, it is impossible to perform detection on potentials with high precision. So, measurement values occasionally become unstable and incorrect.

### SUMMARY OF THE INVENTION

It is an object of the invention to provide a terminal apparatus that after termination process is performed on the distribution constant transmission path (e.g., coaxial cable), utilizes an electro-optic sampling probe to detect potentials of signals applied to the distribution constant transmission path in a stable manner and with a high precision.

This invention provides a terminal apparatus for an electro-optic sampling probe that performs measurement on signals transmitted on a distribution constant transmission path such as a coaxial cable. The terminal apparatus supports a projection portion of the electro-optic sampling probe. For example, the terminal apparatus as a whole is contained in an adapter case having a cylindrical shape in which an elastic member is provided to support the projection portion of the electro-optic sampling probe.

In the terminal apparatus, an electrode such as a center electrode of a connector connected with the distribution constant transmission path is placed in an electric connection with a contact provided at a tip end of the projection portion of the electro-optic sampling probe. The terminal apparatus has a terminal circuit, which performs termination process on the distribution constant transmission path. Herein, the terminal circuit has impedance which is substantially equivalent to impedance of the distribution constant transmission path. For example, the terminal circuit is configured using a terminal resistor which is connected to the electrode.

Due to the termination process which is performed by the terminal apparatus with respect to the distribution constant transmission path, the electro-optic sampling probe is capable of performing high-precision measurement in a stable manner on (potentials of) signals transmitted on the distribution constant transmission path.

### BRIEF DESCRIPTION OF THE DRAWINGS

These and other objects, aspects and embodiment of the present invention will be described in more detail with reference to the following drawing figures, of which:
FIG. 1 is a sectional view showing a construction of a terminal apparatus in accordance with embodiment 1 of the invention;
FIG. 2 is a perspective view showing a connection-engaged state that the terminal apparatus is connected to an electro-optic sampling probe;
FIG. 3 is a perspective view showing a connection-released state that connection engaged between the terminal apparatus and electro-optic sampling probe is released;
FIG. 4 is a sectional view showing a cross section of an essential part of the terminal apparatus in accordance with embodiment 2 of the invention;
FIG. 5 is a conceptual view showing an example of usage of the terminal apparatus in connection with the electro-optic sampling probe and oscilloscope;
FIG. 6 is a side view showing an essential part of a terminal apparatus in accordance with embodiment 3 of the invention;
FIG. 7 is a front view showing a terminal apparatus in accordance with embodiment 4 of the invention; and
FIG. 8 is a plan view showing the terminal apparatus in accordance with the embodiment 4 of the invention.

### DESCRIPTION OF THE PREFERRED EMBODIMENT

This invention will be described in further detail by way of examples with reference to the accompanying drawings.

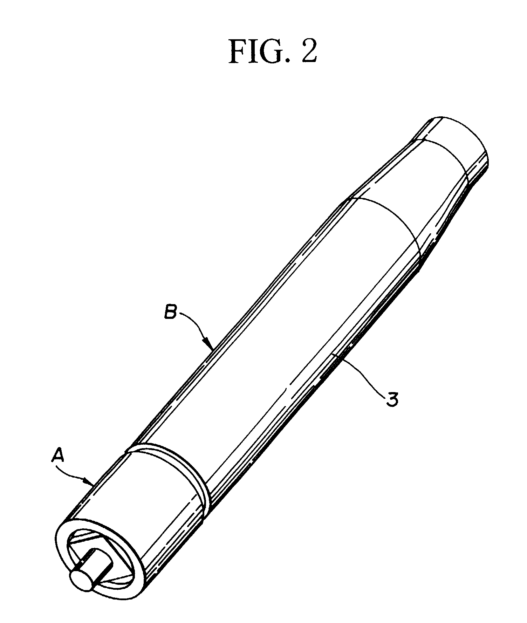

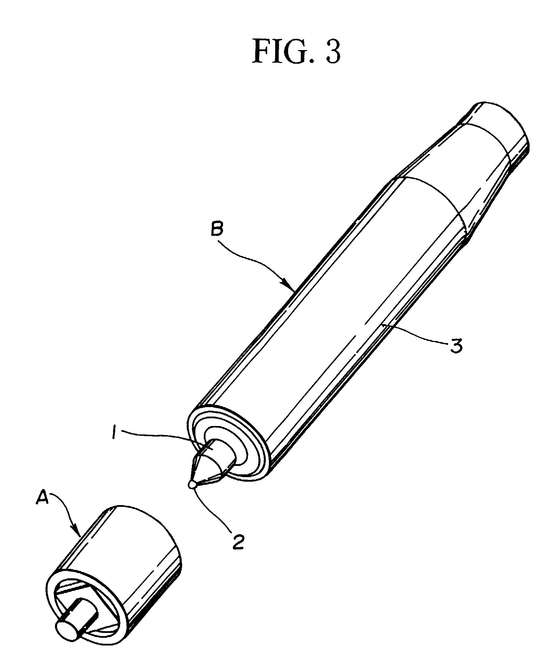

FIG. 2 and FIG. 3 are perspective views showing a terminal apparatus A and an electro-optic sampling probe B in accordance with embodiment 1 of the invention. Specifically, FIG. 2 shows a connection-engaged state of the terminal apparatus A and the electro-optic sampling probe B, while FIG. 3 shows a connection-released state of them. As shown in FIG. 3, a contact 2 formed at a tip end of a projection portion 1 is attached to one end of an electro-optic material (not shown), which is stored in a case 3 of the electro-optic sampling probe B. In response to variations of strength of electric field which are detected by the contact 2, laser beams given from the external are subjected to variations in polarization. Then, the electro-optic sampling probe B extracts the laser beams subjected to variations in polarization, which are then supplied to a polarization detection optical system. The polarization detection optical system processes the extracted laser beams to convert them to electric signals. Thus, it is possible to measure a potential value of a signal applied to an electrode (which will be described later), which is placed in contact with the contact 2.

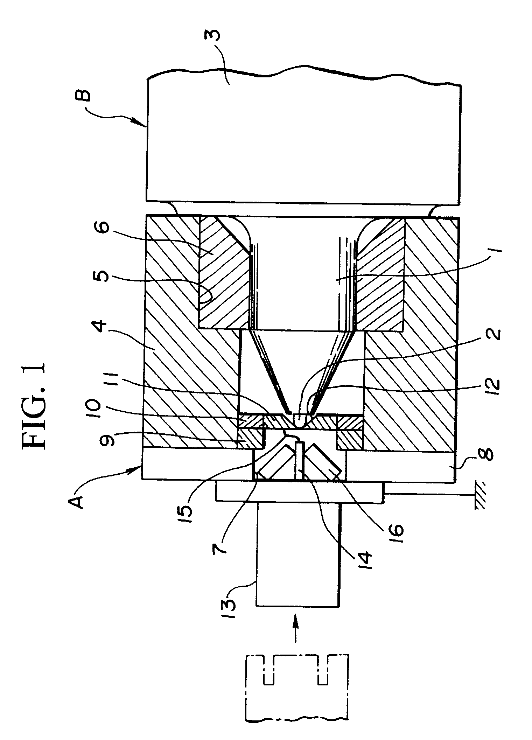

FIG. 1 shows a construction of the terminal apparatus A, which is constructed using a cylinder member 4. The cylinder member 4 is designed as an adapter case, wherein a ring-shaped elastic member 6 is attached to a ring cutout portion 5, which is formed at inner periphery of one end of the cylinder member 4. The cylinder member 4 is made of metal material, for example. An internal diameter of the elastic member 6 is set at prescribed dimensions, which are determined as follows:

When the elastic member 6 is elastically brought in contact with outer periphery of the projection portion 1 of the electro-optic sampling probe B, the internal diameter is set such that the case 3 as a whole can be supported in a horizontal manner while the elastic member 6 can be freely attached to and detached from the projection portion 1.

In addition, a connector attachment plate 8 having a center hole 7 is attached to a surface of another end of the cylinder member 4.

On an interior surface of the cylinder member 4, a support ring 9 and a disk-shaped electrode 11 are attached to be partially overlapped with each other in proximity to the center hole 7 of the connector attachment plate 8. Herein, the support ring 9 is made of insulating material while the electrode 11 is equipped with an insulation ring 10 which is attached to periphery of the electrode 11. A contact receptor 12 is formed as a recess, which is formed at a center portion of the electrode 11 such that a cross section thereof has a conic shape. The projection portion 1 is inserted into the elastic member 6, wherein the contact 2 is formed at the tip end of the projection portion 1. So, the contact receptor 12 functions to certainly contact with and certainly support the contact 2 of the projection portion 1.

A connector 13 is attached to an outer surface of the connector attachment plate 8 and is connected with one end of the coaxial cable, which is the distribution constant transmission path. A center electrode 14 of the connector 13 is connected to the coaxial cable and is used as a part of the distribution constant transmission path. The center electrode 14 penetrates through the center hole 7 of the connector attachment plate 8. In addition, a connection line 15 is provided by solder between the electrode 11 and the center electrode 14 of the connector 13. Further, a resistor 16 is provided at a terminal end of the distribution constant transmission path, wherein it is used as a terminal circuit corresponding to impedance of the distribution constant transmission path. The resistor 16 is provided between the center electrode 14 and a ground potential side of the connector 13. For example, a resistor of 50 Ω is used as the resistor 16.

Using the terminal apparatus A which is constructed as described above to have the electrode 11 and the terminal resistor 16, measurement is performed with respect to potentials of signals applied to the coaxial cable which is the distribution constant transmission path. In that case, one end of the coaxial cable is connected to the connector 13. In connection with such connecting operation, a human operator presses the projection portion 1 of the electro-optic sampling probe B to insert it into the ring-shaped elastic member 6 attached to the interior portion of the cylinder member 4, so that the contact 12 is brought into contact with the contact receptor 12 of the electrode 11 provided inside of the cylinder member 4.

Thus, one end of the coaxial cable is terminated by the terminal resistor 16 by means of the center electrode 14 of the connector 13. Due to such construction, it is possible to avoid reflection, interference and loss of electric signals at one end of the coaxial cable. Potentials of signals of the center electrode 14 are transmitted to the electrode 11 via the connection line 15. Using the contact 2 of the electro-optic sampling probe B which contacts with the electrode 11, it is possible to perform measurement of potentials of signals of the distribution constant transmission path in a stable manner and with high precision on the basis of polarization variations of laser beams that occur due to variations of strength of electric field.

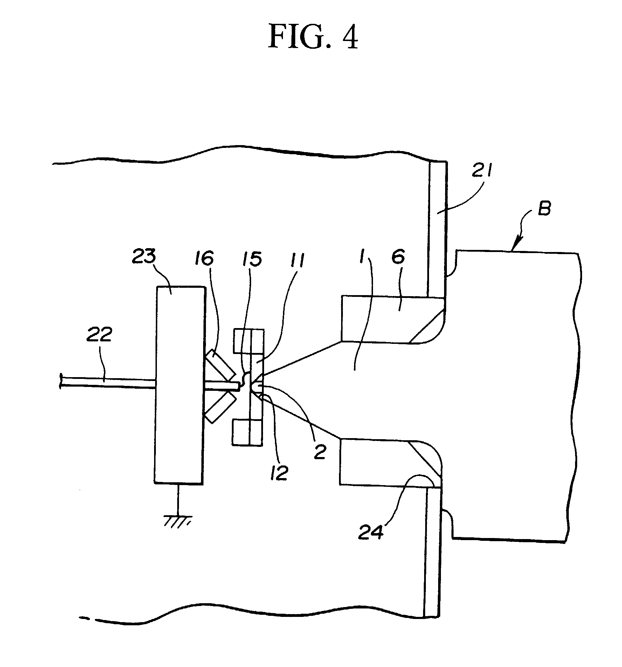

FIG. 4 shows a part of a terminal apparatus in accordance with embodiment 2 of the invention. This embodiment 2 is constructed such that a set of the electrode 11 and the terminal resistor 16, which construct a part of the terminal apparatus, are provided inside of a panel 21 of an oscilloscope. The terminal resistor 16 is connected between a conductor (or core line) 22 of the coaxial cable and an earth ring 23. Herein, the conductor 22 penetrates through the earth ring 23 via insulating material (not shown). Incidentally, it is possible to use the electrode 11 as a calibration electrode that the oscilloscope originally has.

An attachment hole 24 is formed at a selected area of the panel 21, which is located in connection with the electrode 11. The elastic member 6 is fixed to the attachment hole 24 as a support member for supporting the electro-optic sampling probe B. When the projection portion 1 of the electro-optic sampling probe B is inserted into and supported by the elastic member 6, the contact 2 of the electro-optic sampling probe B is brought into contact with the contact receptor 12 of the electrode 11 such that the contact 2 engages with the contact receptor 12.

According to the terminal apparatus of the embodiment 2 described above, it is possible to perform termination in a proper manner with respect to the coaxial cable, which is used for output of the oscilloscope. Therefore, the electro-optic sampling probe B is capable of performing high-precision measurement on potentials of signals which are applied to the coaxial cable. Incidentally, the electrode 11 can be used as a calibration electrode connected to one end of the coaxial cable, for example.

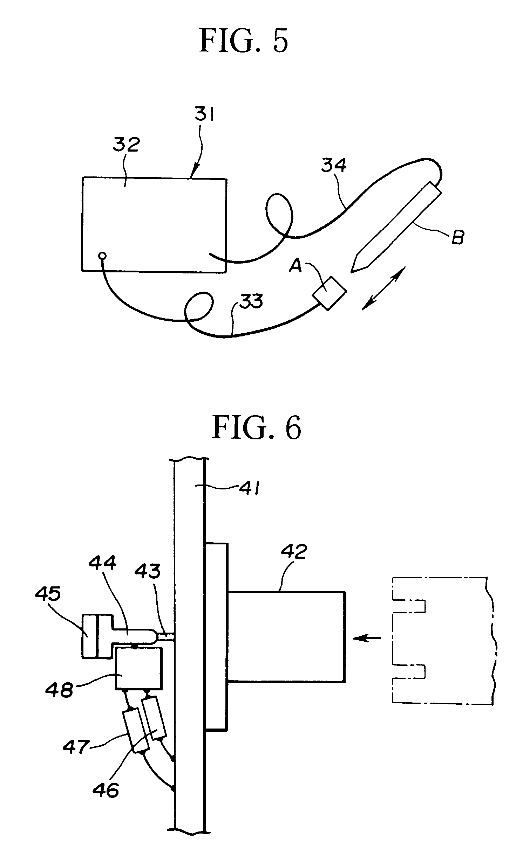

FIG. 5 shows an example of usage of the terminal apparatus in connection with the electro-optic sampling probe and oscilloscope. In FIG. 5, an oscilloscope 31 has a panel 32, from which a coaxial cable 33 is extended and from which a probe cable 34 is extended and connected to the electro-optic sampling probe B. A calibration electrode of the oscilloscope 31 is provided inside of the terminal apparatus A, which is connected to the coaxial cable 33. Herein, the terminal apparatus A has the same configuration and same functions of the foregoing terminal apparatus shown in FIG. 1. The electrode 11 is used as the calibration electrode connected to the coaxial cable 33. Therefore, another end of the coaxial cable 33 whose one end is connected to the terminal apparatus A is connected to a calibration circuit (not shown), which is provided inside of the panel 32 of the oscilloscope 31.

Like the foregoing terminal apparatus shown in FIG. 1, the terminal apparatus A is attached to the tip end of the electro-optic sampling probe B in a free detachable manner. Therefore, it is possible to protect the contact 2. At an attached mode that the terminal apparatus A is attached to the electro-optic sampling probe B, it is possible to automatically perform calibration of the electro-optic sampling probe B. At the attached mode, if the electro-optic sampling probe B measures a potential of a signal applied to the coaxial cable 33 to be at 1 V, for example, it is possible to judge that oscilloscope 31 functions normally. For this reason, it is unnecessary to provide a protection member exclusively used for protection of the contact 2 of the electro-optic sampling probe B. Incidentally, signals measured by the electro-optic sampling probe B are input to a measurement terminal of the oscilloscope 31 via the probe cable 34.

FIG. 6 shows a part of a terminal apparatus in accordance with embodiment 3 of the invention. In FIG. 6, a connector 42 for connection of a coaxial cable is provided outside of a panel 41 of an oscilloscope. A center electrode 43, which is an electrode of the connector 42, projects inside of the panel 41. A metal member 44, provided inside of the panel 41, is brought into contact with an end of the center electrode 43. An electro-optic material 45 contacts with the metal member 44. The aforementioned metal member 44 and the electro-optic material 45 are assembled together with an optical system (not shown) to construct an electro-optic sampling device. Between the metal member 44 (or center electrode 43) and the panel 41 defining earth potential (or ground potential), there are provided terminal resistors 46 and 47, which are selected by a switch 48. So, either the terminal resistor 46 or 47 is selectively connected with the metal member 44 (or center electrode 43). For example, the terminal resistor 46 has resistance of 50 Ω while the terminal resistor 47 has resistance of 1 MΩ.

Now, the coaxial cable is connected to the connector 42 so that electric connection is established between the coaxial cable and the center electrode 43. So, the terminal apparatus performs termination process of the coaxial cable by using either the terminal resistor 46 or 47. Thus, the electro-optic sampling device is capable of performing high-precision detection on potentials of signals transmitted on the coaxial cable.

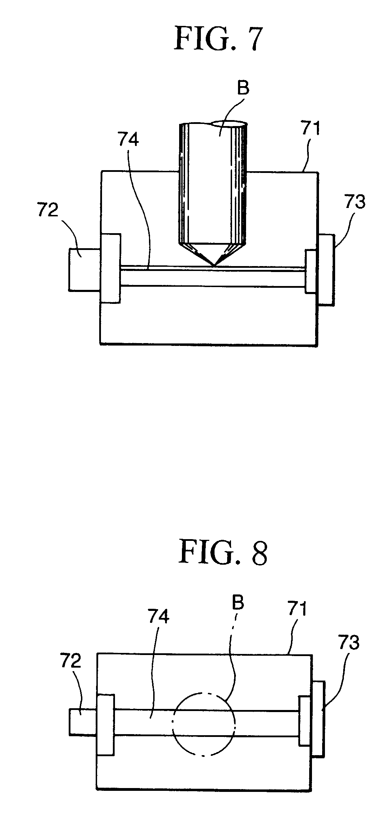

FIG. 7 and FIG. 8 show a terminal apparatus in accordance with embodiment 4 of the invention. Herein, a body 71 is equipped with an electric input terminal 72 and a terminal device 73, which are connected together by a microstrip line 74. Specifically, the electric input terminal 72 corresponding to a SMA connector, for example, (where "SMA" is an abbreviation for "small coaxial connector") is attached to one end of the body 71, while the terminal device 73 is attached to another end of the body 71, wherein a contact corresponding to a tip end of an electro-optic sampling probe B is brought into contact with the microstrip line 74 that connects the electric input terminal 72 and the terminal device 73. In the aforementioned terminal apparatus, it is possible to perform high-precision measurement on potentials of the microstrip line 74 by merely bringing the contact of the electro-optic sampling probe B into contact with the microstrip line 74. In the embodiment 4, the body 71 is capable of arbitrarily functioning as a protection member that supports the electro-optic sampling probe B.

As this invention may be embodied in several forms without departing from the spirit of essential characteristics thereof, the present embodiments are therefore illustrative and not restrictive, since the scope of the invention is defined by the appended claims rather than by the description preceding them, and all changes that fall within metes and bounds of the claims, or equivalence of such metes and bounds are therefore intended to be embraced by the claims.

## Claims

1. A terminal apparatus comprising:
a terminal circuit which is connected to a terminal end of a distribution constant transmission path and which has impedance substantially equivalent to the distribution constant transmission path; and
an electrode which is connected to a circuit connecting the distribution constant transmission path and the terminal circuit together and which is placed in an electric contact with a contact of an electro-optic sampling probe.

2. A terminal apparatus according to claim 1 wherein the terminal circuit and the electrode are provided inside of an adapter case, which is attached to a tip end of the electro-optic sampling probe in a free detachable manner.

3. A terminal apparatus according to claim 1 wherein the terminal circuit and the electrode are provided inside of a panel of an oscilloscope and wherein the panel is equipped with a probe support member for supporting the tip end of the electro-optic sampling probe in a free attachable and detachable manner.

4. A terminal apparatus according to claim 2 or 3 wherein the terminal circuit and the electrode construct a calibration terminal of an electro-optic oscilloscope.

5. A terminal apparatus provided for an electro-optic sampling probe that performs measurement on signals transmitted through a distribution constant transmission path, said terminal apparatus comprising:
support means for supporting a projection portion of the electro-optic sampling probe;
electrode means which is connected with the distribution constant transmission path and which is electrically connected to a contact of the projection portion of the electro-optic sampling probe; and
terminal circuit means for performing termination process on the distribution constant transmission path, wherein the terminal circuit means has impedance which is substantially equivalent to impedance of the distribution constant transmission path.

6. A terminal apparatus according to claim 5 wherein the electrode means corresponds to a center electrode of a connector which is connected to the distribution constant transmission path.

7. A terminal apparatus according to claim 5 wherein the terminal circuit means is configured using a terminal resistor which is connected to the electrode means.

8. A terminal apparatus according to claim 5 wherein the distribution constant transmission path is a coaxial cable.

9. A terminal apparatus provided for an electro-optic sampling probe that performs measurement on signals transmitted through a distribution constant transmission path, said terminal apparatus comprising:
a connector which is connected to the distribution constant transmission path;
a terminal device for performing termination process on the distribution constant transmission path; and
a microstrip line for connecting the connector and the terminal device together, wherein a contact of the electro-optic sampling probe is brought into contact with the microstrip line.

10. A terminal apparatus according to claim 9 wherein the distribution constant transmission path is a coaxial cable.

11. An electro-optic probe arrangement, comprising an electro-optic probe (B) with a tip (2) to sense an electrical potential, and an optical arrangement responsive to the potential to derive an output as a function thereof, **characterised by** a terminal device (A) configured to be electrically connected to an end of an elongate, longitudinally externally insulated electrical conductor, and to receive the tip of the probe to form an electrical connection between the probe and the end of the elongate conductor.
